# EUROPÄISCHE PATENTSCHRIFT

(11) **EP 1 627 425 B1**
(45) Veröffentlichungstag und Bekanntmachung des Hinweises auf die Patenterteilung: **30.08.2006**
(21) Anmeldenummer: 04731597.3
(22) Anmeldetag: 07.05.2004
(51) Int. Cl.: H01L 21/58

(54) **VERFAHREN ZUM HERSTELLEN EINER CHIPANORDNUNG UND LACK MIT MAGNETISCH LEITFÄHIGEN PARTIKELN ZUR ELEKTRISCHEN KONTAKTIERUNG DER CHIPS**
METHOD FOR THE PRODUCTION OF A CHIP ARRANGEMENT AND VARNISH FOR CARRYING OUT SAID METHOD
PROCEDE DE PRODUCTION D'UN ENSEMBLE DE PUCES ET VERNIS PERMETTANT DE METTRE EN OEUVRE CE PROCEDE

(30) Priorität: 23.05.2003 DE 10323842
(43) Veröffentlichungstag der Anmeldung: 22.02.2006
(73) Patentinhaber: Micronas Holding GmbH, 79108 Freiburg (DE)
(72) Erfinder: KLAPPROTH, Holger, 79108 Freiburg (DE)
(74) Vertreter: Huwer, Andreas
(86) Internationale Anmeldenummer: PCT/EP2004/004879
(87) Internationale Veröffentlichungsnummer: WO 2004/105119

(56) Entgegenhaltungen:
- DE-A1- 2 902 002
- US-A- 4 283 591
- US-A- 4 546 037

## Beschreibung

Die Erfindung betrifft ein Verfahren zum Herstellen einer Chipanordnung, wobei mindestens zwei, jeweils wenigstens eine elektrische Kontaktstelle aufweisende Halbleiterchips bereitgestellt werden, wobei die Kontaktstelle(n) mindestens eines der Halbleiterchips mit einer elektrisch leitfähige Partikel aufweisenden Kontaktierungsschicht beschichtet wird (werden), wobei die Halbleiterchips derart angeordnet werden, dass sie mit ihren Kontaktstellen einander zugewandt und die Kontaktstellen durch die zwischen ihnen befindliche Kontaktierungsschicht miteinander verbunden sind, wobei die Kontaktierungsschicht aus magnetisch leitfähigen Partikeln und einem ersten Isolierwerkstoff hergestellt wird, in dem die Partikel mit Abstand zueinander und zu den Kontaktstellen angeordnet werden, wobei der erste Isolierwerkstoff in flüssiger Form auf die Kontaktstelle(n) aufgebracht und danach verfestigt wird, wobei der Isolierwerkstoff nach dem Beschichten der Kontaktstelle(n) mit der Kontaktierungsschicht durch eine Wärmebehandlung zumindest in einem zwischen den Kontaktstellen befindlichen Bereich aufgeschmolzen wird, wobei in dem aufgeschmolzen Bereich die Lage wenigstens eines Partikels mit Hilfe eines Magnetfelds derart verändert wird, dass die Kontaktstellen über den wenigstens einen Partikel elektrisch miteinander verbunden sind, und wobei der Isolierwerkstoff danach durch Abkühlen verfestigt wird. Außerdem bezieht sich die Erfindung auf einen Lack zur Durchführung des Verfahrens.

Aus DE 29 02 002 A1 ist ein Verfahren der eingangs genannten Art bekannt, bei dem mehrere Halbleiterchips zu einem Scheibenstapel übereinander angeordneten werden. Dabei ist zwischen zueinander benachbarten Halbleiterchips des Scheibenstapels jeweils eine Kontaktierungsschicht angeordnet, durch welche die Halbleiterchips voneinander beabstandet sind. Die Kontaktierungsschichten bestehen jeweils aus einem elektrischen Isolierwerkstoff, nämlich einem Klebstoff, in dem viele kleine nadelförmige ferromagnetische Partikel eingebettet sind, die zur Verbesserung der elektrischen Leitfähigkeit mit einem Edelmetall überzogen sind. Während des Aushärtens des Klebstoffs wird der Halbleiter-Scheibenstapel in einem technischen Magnetfeld angeordnet, so dass ein Kontakt entsteht. Die Leitfähigkeit des nichtleitenden Materials wird lokal irreversibel durch Erhitzen mit Laserstrahlen erhöht.

Damit bei diesem Verfahren vermieden wird, dass ferromagnetische Partikel, die nicht in dem Magnetfeld ausgerichtet wurden, miteinander in Kontakt geraten und Kurzschlüsse und/oder ein Übersprechen zwischen den in den einzelnen Kontaktierungsschichten erzeugten, die an die Kontaktierungsschichten angrenzenden Halbleiterchips miteinander verbindenden elektrischen Pfaden hervorrufen, weisen die elektrisch leitenden Partikel eine relativ geringe Dichte in dem Isolierwerkstoff auf Dies hat jedoch den Nachteil, dass die mit Hilfe des Laserstrahls und des Magnetfelds erzeugten elektrischen Pfade nur eine entsprechend geringe Leitfähigkeit aufweisen. Bei Halbleiterchips mit geringer Strukturgröße und somit entsprechend kleinen Kontaktstelle können außerdem Fehler bei der Kontaktierung der Kontaktstellen auftreten.

Es besteht deshalb die Aufgabe, ein Verfahren der eingangs genannten Art zu schaffen, mit dem insbesondere kleine Kontaktstellen der Halbleiterchips sicher und elektrisch gut leitend miteinander verbunden werden können, wobei ein Übersprechen zwischen den in dem Isolierwerkstoff gebildeten, die Halbleiterchips miteinander verbindenden elektrischen Pfaden weitestgehend vermieden werden soll. Femer besteht die Aufgabe, einen Lack zur Durchführung des Verfahrens anzugeben.

Diese Aufgabe wird bei dem eingangs genannten Verfahren dadurch gelöst, dass die Partikel mit einem zweiten, durch ein Polymer gebildeten Isolierwerkstoff ummantelt und danach auf die Kontaktstelle(n) des mindestens einen Halbleiterchips aufgebracht werden, und dass bei der Wärmebehandlung zusätzlich zu dem ersten Isolierwerkstoff auch der zweite Isolierwerkstoff aufgeschmolzen wird.

In vorteilhafter Weise sind also die Partikel in dem in flüssiger Form auf die Kontaktstellen aufgebrachten ersten Isolierwerkstoff zumindest durch den sie ummantelnden, festen zweiten Isolierwerkstoff voneinander beabstandet und elektrisch gegeneinander isoliert, so dass sie mit einer großen Dichte in dem flüssigen ersten Isolierwerkstoff angeordnet sein können, ohne dass die Gefahr besteht, dass sie mit den Kontaktstellen der Halbleiterchips und/oder anderen Partikeln Berührung geraten. Bei der Wärmebehandlung wird der zweite Isolierwerkstoff an den Stellen, an denen eine elektrische Kontaktierung zwischen den Partikeln und den Kontaktstellen und/oder weiteren Partikeln erfolgen soll, aufgeschmolzen. Somit sind Partikel, deren Ummantelung bei der Wärmebehandlung nicht aufgeschmolzen wurde, weiterhin gegen die Kontaktstellen der Halbleiterchips und/oder die anderen Partikel elektrisch isoliert, do dass sie keine leitenden Brücken bilden können, die ein Übersprechen und oder einen Kurzschluss zwischen Kontaktstellen, die nicht miteinander verbunden werden sollen, verursachen könnten. Durch den scheinbar unnötigen zweiten Isolierwerkstoff wird also eine hohe Dichte der Partikel in der Kontaktierungsschicht ermöglicht. Somit kann an den Stellen, an denen bei der Wärmebehandlung die Isolierwerkstoffe aufgeschmolzen wurden, eine gute elektrische Kontaktierung erreicht werden. Der zweite Isolierwerkstoff weist vorzugsweise einen höheren Schmelzpunkt auf als der erste Isolierwerkstoff.

Die Lage der für die elektrischen Verbindungen zwischen den Kontaktstellen der Halbleiterchips in der Kontaktierungsschicht vorgesehenen elektrisch leitfähigen Bereiche wird dadurch definiert, dass die Isolierwerkstoffe, an den Stellen, an denen die leitfähigen Bereiche angeordnet werden sollen, geschmolzen werden, um danach die Lage, welche die Partikel relativ zueinander und relativ zu den Kontaktstellen aufweisen, derart zu verändern, dass die Partikel Brücken bilden, welche die Kontaktstellen jeweils elektrisch miteinander verbinden. Nach der Herstellung der Brücken werden die geschmolzenen Isolierwerkstoffe verfestigt, so dass die Partikel, welche die Brücken bildet, dann ihre Lage dauerhaft beibehalten und das Magnetfeld somit entfernt werden kann. Die Lage der Stellen, an denen die Brücken gebildet werden, lässt sich also durch gezielte Wärmeeinbringung in die Isolierwerkstoffe auf einfache Weise "programmieren", so dass in die Halbleiterchips integrierte elektrische Bauelemente und/oder Schaltkreise nahezu nach Belieben miteinander verschaltet werden können. Somit lässt sich auf einfache Weise aus baugleichen Halbleiterchips eine Vielzahl unterschiedlicher Chipanordnungen herstellen. Selbstverständlich ist es aber auch möglich, mit dem Verfahren nacheinander wahl- oder wechselweise unterschiedliche Halbleiterchips elektrisch miteinander zu verbinden, wobei die Stellen, an denen die Isolierwerkstoffe aufgeschmolzen werden, jeweils an die Lage der Kontaktstellen der entsprechenden Halbleiterchips angepasst werden. Bei dem Verfahren werden die miteinander zu verbindenden Halbleiterchips vorzugsweise mit der Kontaktierungsschicht beschichtet bevor sie mit den Kontaktstellen einander zugewandt relativ zueinander positioniert werden. Es ist aber auch eine umgekehrte Vorgehensweise denkbar, bei welcher die Halbleiterchips zunächst derart relativ zueinander positioniert werden, dass sie mit ihren Kontaktstellen einander zugewandt und durch einen Zwischenraum voneinander beabstandet sind. In diesen Zwischenraum kann danach die Kontaktierungsschicht eingebracht werden. Die Partikel werden vorzugsweise aus einem ferromagnetischen Werkstoff hergestellt, insbesondere aus Eisen. Die Isolierwerkstoffe können einen Korrosionsschutz für die Partikel bilden.

Der erste Isolierwerkstoff kann ein Lack oder eine Vergussmasse und der zweite Isolierwerkstoff ein Polymer sein. Durch die Polymerbeschichtung oder das Coating der Partikel wird eine besonders gute elektrische Isolation der Partikel gegeneinander und/oder gegen die Kontaktstelle(n) erreicht. Die Ummantelung besteht vorzugsweise aus einem Polymerwerkstoff, der in dem Lösungsmittel der Vergussmasse nicht oder nur schlecht löslich ist, so dass die Partikel nach dem Einbringen in die Vergussmasse weiterhin mit dem Polymerwerkstoff ummantelt sind. Der Polymerwerkstoff kann ein niedermolekulares Polystyrol sein. Auch die Vergussmasse kann einen Polymerwerkstoff enthalten.

Bei einer vorteilhaften Ausführungsform der Erfindung sind die Partikel als längliche, vorzugsweise stabförmige Elemente ausgebildet. Die Partikel können dann durch das Magnetfeld in eine bestimmte Richtung ausgerichtet werden, um die Kontakt stellen der Halbleiterchips miteinander zu verbinden.

Zweckmäßigerweise wird die Kontaktierungsschicht derart auf die mindestens eine Kontaktstelle aufgebracht, dass die Partikel mit ihrer Längserstreckung etwa parallel zur Oberfläche der Kontaktstelle ausgerichtet sind und nach dem Aufschmelzen des mindestens einen Isolierwerkstoffs wird mit Hilfe des Magnetfelds mindestens ein Partikel quer und insbesondere etwa rechtwinklig zur Oberfläche der Kontaktstelle ausgerichtet. Durch diese Maßnahme können auch Halbleiterchips mit geringer Strukturgröße und somit entsprechende kleinen Kontaktstellen sicher kontaktiert werden.

Bei einer bevorzugten Ausführungsform der Erfindung weisen die Partikel Spitzen oder Kanten auf und sind vorzugsweise nadelförmig ausgebildet, wobei die Partikel mit Hilfe des Magnetfelds derart in dem Isolierwerkstoff ausgerichtet und/oder positioniert werden, dass wenigstens ein Partikel mit mindestens einer Spitze oder Kante eine Kontaktstelle berührt und/oder in den Werkstoff der Kontaktstelle eindringt. Dadurch wird eine hohe elektrische Leitfähigkeit der durch die Partikel gebildeten, die Kontaktstellen miteinander verbindenden Brücke und somit eine geringe Verlustleistung an den Kontaktstellen sowohl zwischen zueinander benachbarten Partikeln als auch zwischen den Partikeln und den Kontaktstellen erreicht. Dabei ist es erwünscht, dass die Partikel mit ihren Spitzen eine Oxidschicht, mit der die Kontaktstellen überzogen sind, durchdringen. Dies kann dadurch erreicht werden, dass der lsolationsstoff sich beim Erwärmen der Kontaktierungsschicht stärker ausdehnt und/oder sich beim Abkühlen der Kontaktierungsschicht stärker zusammenzieht als die Partikel.

Der erste Isolierwerkstoff kann, nachdem er in flüssiger Form auf mindestens einen der Halbleiterchips aufgebracht wurde, durch Verdunsten eines in dem lsolierwerkstoff enthaltenen Lösungsmittels verfestigt werden. Der Isolierwerkstoff und gegebenenfalls die darin enthaltenen, mit dem zweiten Isolierwerkstoff ummantelten Partikel können dann auf einfache Weise beispielsweise im Schleuderverfahren auf den Halbleiterchip aufgebracht werden. Als lsolierwerkstoff kann Polyacrylsäure verwendet werden, wobei das Lösungsmittel Wasser sein kann.

Vorteilhaft ist, wenn der Abstand der einander zugewandten Kontaktstellen der Halbleiterchips größer gewählt wird als die Länge der Partikel, und wenn nach dem Aufschmelzen des mindestens einen Isolierwerkstoffs mindestens zwei Partikel mit Hilfe des Magnetfelds derart in Erstreckungsrichtung der Partikel zueinander versetzt angeordnet werden, dass sie wenigstens eine sich durchgängig über mehrere Partikel erstreckende Partikelreihe bilden, welche die Kontaktstellen elektrisch miteinander verbindet. Die Partikel können sich dann beim Einbringen der elektrischen Verbindungen in die Kontaktierungsschicht in dem Magnetfeld besonders gut ausrichten. Die elektrische Verbindung zwischen den Kontaktstellen der Halbleiterchips erfolgt jeweils über mehrere in Reihe geschaltete Partikel, wobei gegebenenfalls mehrere Partikelreihen zueinander parallel geschaltet sein können.

Bei einer zweckmäßigen Ausgestaltung der Erfindung werden die Halbleiterchips derart angeordnet, dass sie mit ihren Erstreckungsebenen parallel zueinander verlaufen und durch die Kontaktierungsschicht voneinander beabstandet sind. Die Halbleiterchips und die Kontaktierungsschicht(en) bilden dann einen Schichtstapel, der eine besonders kompakte Anordnung der Halbleiterchips ermöglicht.

Die Wärmebehandlung erfolgt vorzugsweise durch Bestrahlung der Kontaktierungsschicht mit elektromagnetischer Strahlung, insbesondere mit Infrarotstrahlung und/oder Mikrowellen, wobei die Strahlung vorzugsweise durch wenigstens einen der Halbleiterchips hindurch in die Kontaktierungsschicht eingekoppelt Wird. Durch diese Maßnahme wird eine lokale, auf ein kleines Teilvolumen der Kontaktierungsschicht begrenzte Wärmebehandlung ermöglicht, wobei die Wärme durch den wenigstens einen Halbleiterchip hindurch auch in einen von dem (den) Halbleitechip(s) überdeckten Bereiche der Kontaktierungsschicht eingebracht werden kann. Die Wellenlänge der Strahlung liegt vorzugsweise in einem Bereich, in dem der (die) Halbleiterchips für die Strahlung weitgehend transparent ist. Bei Halbleiterchips mit einem Substrat aus Silizium ist diese beispielsweise bei Infrarot-Strahlung der Fall, wenn die Wellenlänge der Strahlung größer als 1080 nm ist.

Vorteilhaft ist, wenn die Strahlung zu einem Energiestrahl gebündelt wird, und wenn der Energiestrahl nacheinander auf wenigstens zwei voneinander beabstandete Bereiche der Kontaktierungsschicht gerichtet wird. Der Energiestrahl kann mit Hilfe eines Lasers und/oder eines Masers mit relativ großer Energiedichte erzeugt werden. Der Energiestrahl kann dann mit einer Ablenkeinrichtung, die einen oder mehrere verschwenkbare Ablenkspiegel aufweisen kann, auf einfache Weise auf die Stellen der Kontaktierungsschicht projiziert werden, an denen elektrisch leitfähige Bereiche erzeugt werden sollen. Der Ablenkspiegel kann in an sich bekannter Weise mittels einen Antriebsmotors, wie z.B. einem Galvanometer oder einem. Schrittmotor, verstellt werden. Zur Steuerung des Antriebsmotors kann ein Mikrocomputer vorgesehen sein.

Bei einer vorteilhaften Ausführungsform des Verfahrens wird auf die wenigstens eine elektrische Kontaktstelle mindestens eines Halbleiterchips eine dünne Haftschicht und auf mindestens einen weiteren Halbleiterchip die Kontaktierungsschicht aufgebracht, wobei nach dem Abkühlen der Isolierwerkstoffe der Kontaktierungsschicht die Halbleiterchips derart angeordnet werden, dass sie mit ihren Kontaktstellen einander zugewandt sind und die Haftschicht an der Kontaktierungsschicht anliegt, und wobei die Halbleiterchips danach derart aneinander angepresst werden, dass sich der Isolierwerkstoff plastisch verformt und die Partikel der Kontaktierungsschicht die Haftschicht durchdringen. Die Isolierwerkstoffe werden also zum Ausrichten der Partikel in dem Magnetfeld aufgeschmolzen bevor die Halbleiterchips relativ zueinander positioniert werden, so dass die Kontaktierungsschicht bei der Durchführung der Wärmebehandlung an ihrer dem Halbleiterchip abgewandten Seite frei liegt und somit für die Einkopplung der Strahlung gut zugänglich ist. Erst nach dem Abkühlen bzw. Verfestigen des Isolierwerkstoffs werden die Halbleiterchips zum Anpressen der Kontaktierungsschicht an die Haftschicht relativ zueina n-der positioniert. Dabei wird der Anpressdruck derart gewählt, dass sich die Isolierwerkstoffe plastisch verformen und mit der Haftschicht eine Haftverbindung eingehen. Während des Aneinanderpressens der Kontaktierungsschicht an die Haftschicht durchdringen die Partikel die Haftschicht, so dass sie die dahinter befindliche(n) Kontaktstelle(n) berühren und gegebenenfalls etwas in diese eindringen. Die Haftschicht kann eine Silan-Haftschicht sein, die bevorzugt als Monolage auf den Halbleiterchip aufgebracht wird, beispielsweise durch Tauchbeschichten (Dipcoating). Die Silan-Haftschicht enthält vorzugsweise ein Benzophenon-propyl-triethoxysilan.

Bei einer vorteilhaften Ausführungsform der Erfindung werden mindestens zwei quer zueinander verlaufende Energiestrahlen derart auf die Kontaktierungsschicht ausgerichtet, dass sie sich zwischen zwei Kontaktstellen durchdringen. Dadurch kann die für das Aufschmelzen der Isolierwerkstoffe benötigte Wärme noch genauer in einen lokal begrenzten Bereich der Kontaktierungsschicht eingebracht werden. Die Energie der Energiestrahlen ist dabei derart auf die Schmelztemperaturen der Isolierwerkstoffe abgestimmt, dass diese nur an der Stelle aufgeschmolzen werden, an denen sich die Energiestrahlen durchdringen. Dadurch ist es sogar möglich, bei einer Chipanordnung, die einen Schichtstapel mit mehr als zwei Halbleiterchips aufweist, im Inneren einen lokal begrenzten Bereich einer Kontaktierungsschicht zu schmelzen.

Bei einer anderen vorteilhaften Ausführungsform der Erfindung wird die Mikrowellen- und/oder Infrarot-Strahlung durch eine Maske hindurch auf die Kontaktierungsschicht projiziert, wobei die Maske vorzugsweise an der der Kontaktierungsschicht abgewandten Rückseite eines der Halbleiterchips angeordnet ist. Dadurch können eine Vielzahl von zueinander beabstandeten Stellen der Kontaktierungsschicht gleichzeitig lokal aufgeschmolzen werden.

Vorteilhaft ist, wenn mindestens drei Halbleiterchips mit ihren Erstreckungsebenen etwa parallel zueinander angeordnet und zu einem Schichtstapel miteinander verbunden werden, wenn zwischen zwei zueinander benachbarten Halbleiterchips jeweils eine Kontaktierungsschicht angeordnet wird, und wenn die Isolierwerkstoffe der Kontaktierungsschichten derart gewählt werden, dass die Kontaktierungsschichten für die elektromagnetische Strahlung unterschiedliche Absorptionseigenschaf ten aufweisen. Die Strahlung, mit der die einzelnen Kontaktierungsschichten bereichsweise aufgeschmolzen werden, kann dann jeweils derart auf die Absorptionseigenschaften der Kontaktierungsschichten abgestimmt sein, dass beim Durchstrahlen der Schichtstapelschichten jeweils nur eine der Kontaktierungsschichten aufgeschmolzen wird. Somit können die Halbleiterchips im Innern des Schichtstapels in drei Dimensionen kontaktiert werden. Das Aufschmelzen der lsolierwerkstoffe kann durch Einkoppeln von schmalbandiger Mikrowellen-Strahlung erfolgen, wobei die Isolierwerkstoffe der einzelnen Kontaktierungsschichten Bindungsgruppen aufweisen können, die in unterschiedlichen Wellenlängenbereichen Mikrowellen absorbieren. Die Bindungsgruppen können eine CO-Gruppe (zB. PolyacrylSäure) oder eine NH-Gruppe (z.B. Polyacryl-Amid) umfassen.

Besonders vorteilhaft ist, wenn die Kontaktierungsschicht derart auf wenigstens einen der Halbleiterchips aufgetragen wird, dass sie sich unterbrechungsfrei über mehrere voneinander beabstandete Kontaktstellen des Halbleiterchips erstreckt. Dabei ist es sogar möglich, die Kontaktierungsschicht ganzflächig auf den (die) Halbleiterchip(s) aufzubringen, so dass ein Maskierungsschritt eingespart wird. Die Kontalderungsschicht kann gegebenenfalls auch als Klebstoff zum Verbinden der Halbleiterchips ausgebildet sein.

Bezüglich des Lacks wird die vorstehend genannte Aufgabe dadurch gelöst, dass der Lack ein Lösungsmittel und mindestens einen darin gelösten ersten elektrischen Isolierwerkstoff enthält, der durch Verdunsten des Lösungsmittels verfestigt werden kann, wobei in dem ersten Isolierwerkstoff ferromagnetische Partikel angeordnet sind, wobei die Partikel mit einem zweiten, als Polymer ausgebildeten elektrischen Isolierwerkstoff beschichtet sind, und wobei der in verfestigtem Zustand befindliche erste Isolierwerkstoff und der zweite Isolierwerkstoff durch Wärmeeinwirkung schmelzbar sind. Der zweite Isolierwerkstoff ist in dem Lösungsmittel nicht oder nur sehr schlecht löslich, so dass die in der Lösung befindlichen Partikel zumindest durch die Beschichtung voneinander beabstandet und elektrisch gegeneinander isoliert sind. Mit Hilfe des Lacks kann ein Halbleiterchip auf einfache Weise mit der erfindungsgemäßen Kontaktierungsschicht beschichtet werden, indem der Lack durch Aufsprühen, Eintauchen und/oder im Schleuderverfahren auf den Halbleiterchip aufgebracht und das Lösungsmittel danach verdunstet wird, so dass eine feste, aus dem ersten und zweiten Isolierwerkstoff bestehende Isolierwerkstoffschicht mit darin angeordneten, elektrisch und magnetisch leitfähigen Partikeln auf dem Halbleiterchip zurückbleibt.

Vorzugsweise sind die mit dem zweiten Isolierwerkstoff beschichteten ferromagnefischen Partikel in der aus dem Lösungsmittel und dem ersten einen Isolierwerkstoff bestehenden Lösung suspendiert. Mit der Lösung kann dann eine Kontaktierungsschicht mit gleichmäßig, fein verteilten Partikeln auf den Halbleiterchip aufgebracht werden, so dass auch Halbleiterchips mit kleinen Strukturen mit dem erfindungsgemäßen Verfahren elektrisch kontaktiert werden können. Zur Stabilisierung kann der Lack Suspensionshilfsstoffe enthalten, wie sie aus der Farbenherstellung bekannt sind.

Nachfolgend sind Ausführungsbeispiele der Erfindung anhand der Zeichnung näher erläutert. Es zeigen:
- Fig. 1: einen Teilquerschnitt durch eine Chipanordnung mit zwei Halbleiterchips, die durch eine zwischen diesen befindliche Kontaktierungsschicht miteinander verbunden sind, wobei die Kontaktierungsschicht einen Festkörper-Isolierwerkstoff aufweist, in dem Eisen-Partikel angeordnet sind, die etwa parallel zu den Ebenen der Halbleiterchips ausgerichtet sind,
- Fig. 2: die in Fig. 1 gezeigte Chipanordnung während ein Teilbereich der Kontaktierungsschicht durch Bestrahlung mit Infrarot-Strahlung geschmolzen wird, und
- Fig. 3: die in Rg. 2 gezeigte Chipanordnung während der Bestrahlung eines Teilbereichs der Kontaktierungsschicht mit Infrarot-Strahlung und des Anlegens eines die Ausrichtung der Partikel verändernden magnetischen Felds an die Kontaktierungsschicht.

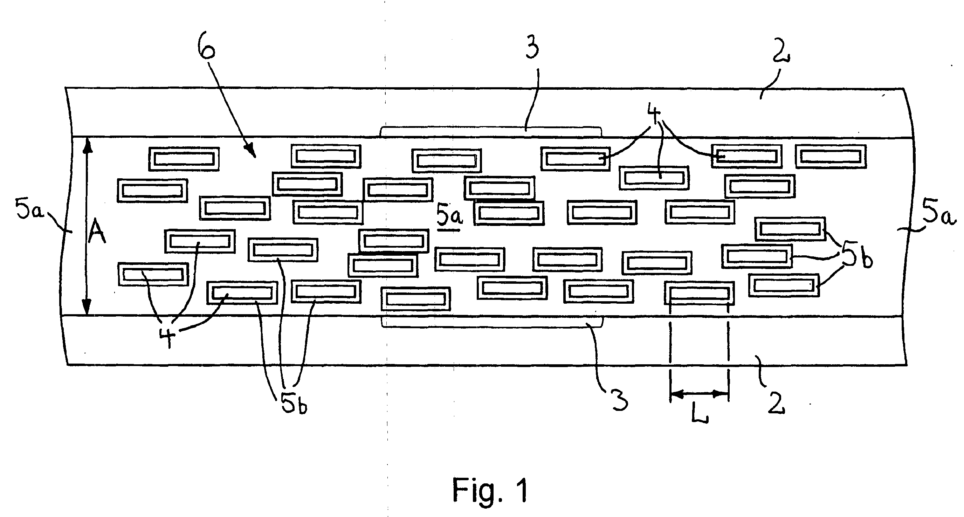

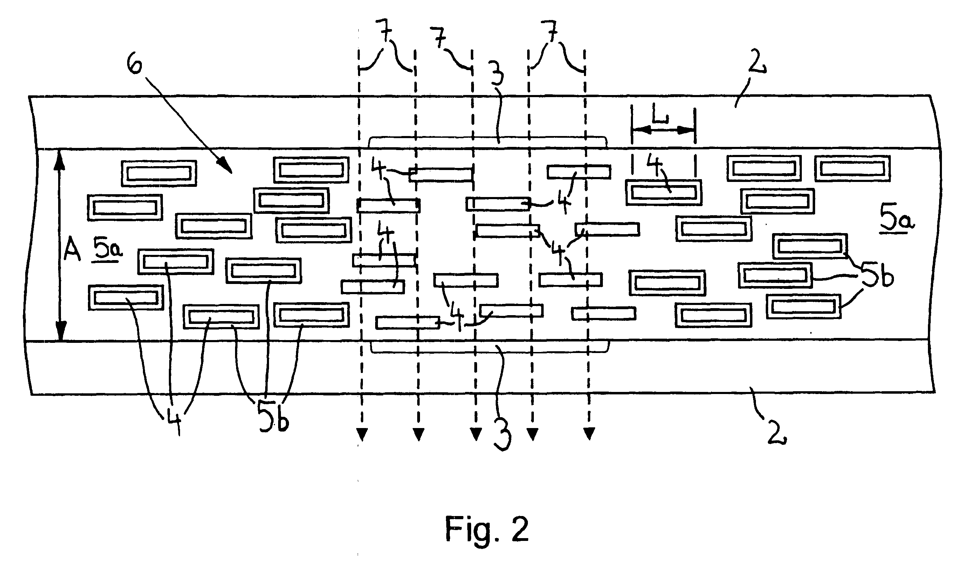

Bei einem Verfahren zum Herstellen einer im Ganzen mit 1 bezeichneten Chipanordnung werden zwei Halbleiterchips 2 bereitgestellt, die jeweils ein SiliziumSubstrat aufweisen, in das in an sich bekannter Weise Schaltkreise für eine elektronische Schaltung integriert sind. Die Schaltkreise weisen elektrische Kontaktstellen 3 auf, die an der Oberfläche oder in einer oberflächennahen Schicht der Halbleiterchips 2 angeordnet und in der Zeichnung nur schematisch dargestellt sind. In den Fig. 1 bis 3 ist für jeden Halbleiterchip 2 aus Gründen der Übersichtlichkeit jeweils nur eine der Kontaktstellen 3 dargestellt Die Halbleiterchips 2 werden derart angeordnet, dass sie mit ihren Kontaktstellen 3 einander zugewandt sind. Zwischen die Halbleiterchips 2 wird eine Kontaktierungsschicht 6 eingebracht, die aus magnetisch leitfähigen Partikeln 4, einen erstem Isolierwerkstoff 5a und einem zweiten Isol ierwerkstoff 5b hergestellt werden.

Die Partikel 4 bestehen aus einem ferromagnetischen, elektrisch leitfähigen Werkstoff, beispielsweise aus Eisen. Die Partikel 4 sind nadelförmig ausgebildet und haben an ihren Enden Spitzen, die in der Zeichnung nicht näher dargestellt sind. Je nach Größe der Kontaktstellen 3 weisen die Partikel 4 etwa eine Länge von 10 nm bis 10 µm auf.

Die Partikel 4 werden derart mit dem zweiten Isolierwerkstoff 5b beschicht, dass sie vollständig mit dem Isolierwerkstoff 5a ummantelt sind. Danach werden die mit dem Isolierwerkstoff 5b beschichteten Partikel 4 in einen Lack eingebracht, der aus dem ersten Isolierwerkstoff 5a und einem Lösungsmittel besteht, In dem der erste Isolierwerkstoff 5a gelöst ist. Der zweite Isolierwerkstoff 5b ist in dem Lösungsmittel unlöslich, so dass die Partikel 4 nach dem Einbringen in den Lack weiterhin von dem zweiten Isolierwerkstoff 5b umhüllt und somit voneinander beabstandet sind.

Mit dem auf diese Weise bereitgestellten Lack werden diejenigen Seiten der Halbleiterchips 2, welche die elektrischen Kontaktstellen 3 aufweisen, jeweils ganzflächig beschichtet. Dabei verhindert der zweite Isolierwerkstoff 5b, dass die elektrisch leitfähigen Partikel 4 mit der Oberfläche der Halbleiterchips 2 in Berührung geraten. Der Lack wird vorzugsweise blasenfrei auf die Oberfläche der Halbleiterchips 2 aufgebracht, beispielsweise im Schleuderverfahren. Bei dem in Fig. 1 gezeigten Ausführungsbeispiel werden die Partikel 4 mit Hilfe eines Magnetfelds mit ihrer Längserstreckung etwa parallel zur Oberfläche der Halbleiterchips 2 ausgerichtet. Während und/oder nach dem Anlegen des Magnetfelds wird der Lach durch Verdunsten des Lösungsmittels verfestigt, so dass die mit ihrer Längserstreckung etwa parallel zur Ebene des Halbleiterchips 2 orientierten, mit dem zweiten Isolierwerkstoff 5b umhüllten ferromagnetischen Partikel 4 dann in dem ersten Isolierwerkstoff 5a in ihrer Lage relativ zu den Halbleiterchips 2 fixiert sind.

Danach werden die Halbleiterchips 2 mit der darauf befindlichen, durch die Isolierwerkstoffe 5a, 5b und die darin eingebetteten Partikeln 4 gebildeten Schichten derart angeordnet, dass diese Schichten an ihren jeweils dem Halbleiterchip 2 abgewandten Seiten flächig aneinander anliegen und die sich durchgängig von dem einen zu dem anderen Halbleiterchip 2 erstreckende Kontaktierungsschicht 6 bilden. In Fig. 1 ist erkennbar, dass die durch die Kontaktierungsschicht 6 voneinander beabstandeten Halbleiterchips 2 mit ihren Erstreckungsebenen etwa parallel zueinander orientiert und mit ihren Kontaktstellen 3 derart einander zugewandt sind, dass jeweils zwei beidseits der Kontaktierungsschicht 6 angeordnete Kontaktstellen 3 paarweise einander gegenüberliegen.

In einem weiteren Verfahrensschritt werden die Isolierwerkstoffe 5a, 5b in den Bereichen, die zwischen den Kontaktstellen 3 angeordnet sind, durch lokale Wärmeeinbringung in die Kontaktierungsschicht 6 aufgeschmolzen. Die Wärmeeinbringung erfolgt in der Weise, dass die entsprechenden Bereiche der Kontaktierungsschicht 6 durch mindestens einen der Halbleiterchips 2 hindurch mit Infrarot-Strahlung 7 bestrahlt wird, welche die Isolierwerkstoffe 5a, 5b absorbieren. Die Infrarotstrahlung wird mittels eines in der Zeichnung nicht näher dargestellten Halbleiter-Lasers in Form eines Laserstrahls erzeugt, der mittels eines verstellbaren Umlenkspiegels nacheinander in die zwischen den jeweils miteinander zu verbindenden Kontaktstellen 3 befindlichen Bereiche der Kontaktierungsschicht 6 projiziert wird. Die Wellenlänge der Infrarot-Strahlung 7 ist so gewählt, dass die Halbleiterchips 2 für die Strahlung 7 im Wesentlichen transparent sind, so dass sie beim Durchtritt durch den mindestens einen Halbleiterchip 2 nicht oder nur unwesentlich abgeschwächt wird.

Die Schmelzpunkte der Isolierwerkstoffe 5a, 5b liegen oberhalb der normalen Betriebstemperatur der Halbleiterchips 2 und sind so gewählt, dass die Isolierwerkstoffe 5a, 5b mittels der Infrarot-Strahlung 7 geschmolzen werden können ohne die Halbleiterchips 2 thermisch zu schädigen.

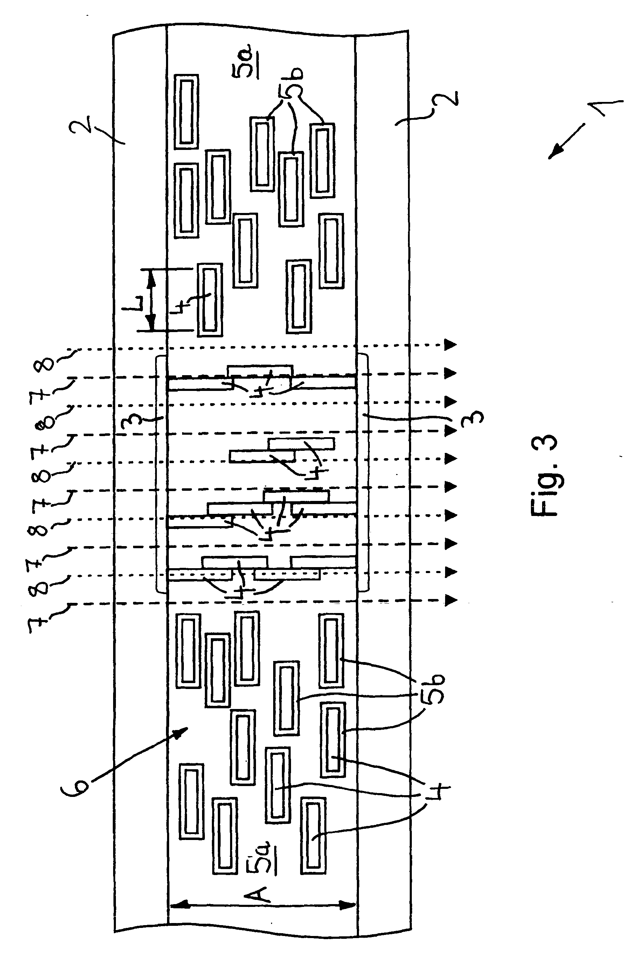

Während die Isolierwerkstoffe 5a, 5b bereichsweise geschmolzen sind, wird ein Magnetfeld 8 erzeugt, das die Kontaktierungsschicht 6 zumindest in den zwischen den Kontaktstellen 3 befindlichen Bereichen etwa normal zu den Erstreckungsebenen der Halbleiterchips 2 durchsetzt. Wie in Fig. 3 besonders gut erkennbar ist, wird durch dieses Magnetfeld in den aufgeschmolzen Bereichen der Isolierwerkstoffe 5a, 5b die Lage und/oder die Orientierung der Partikel 4 derart verändert, dass diese Brücken bilden, welche die paarweise einander gegenüberliegenden Kontaktstellen 3 jeweils elektrisch miteinander verbinden. Danach werden die Isolierwerkstoffe 5a, 5b durch Abkühlen verfestigt, wodurch die Partikel 4 in ihrer Lage relativ zu den Halbleiterchips 2 fixiert werden.

In Fig. 3 ist erkennbar, dass der Abstand A der einander zugewandten Kontaktstellen 3 der Halbleiterchips 2 größer gewählt wird als die Länge L der Partikel 4, und dass nach dem Aufschmelzen der Isolierwerkstoffe 5a, 5b die Partikel 4 in dem Magnetfeld 8 so angeordnet werden, dass jeweils mehrere Partikel 4 in einer quer zu den Erstreckungsebenen der Halbleiterchips 2 verlaufenden Richtung zueinander versetzt angeordnet sind und eine sich durchgängig über mehrere Partikel 4 erstreckende Reihe bilden, die an ihren Enden die Kontaktstellen 3 elektrisch kontakfiert.

## Patentansprüche

1. Verfahren zum Herstellen einer Chipanordnung (1), wobei mindestens zwei, jeweils wenigstens eine elektrische Kontaktstelle (3) aufweisende Halbleiterchips (2) bereitgestellt werden, wobei die Kontaktstelle(n) (3) mindestens eines der Halbleiterchips (2) mit einer ferromagnetisch elektrisch leitfähige Partikel (4) aufweisenden Kontaktierungsschicht (6) beschichtet wird (werden), wobei die Halbleiterchips (2) derart angeordnet werden, dass sie mit ihren Kontaktstellen (3) einander zugewandt und die Kontaktstellen (3) durch die zwischen ihnen befindliche Kontaktierungsschicht (6) miteinander verbunden sind, wobei die Kontaktierungsschicht (6) aus diesen Partikeln (4) und einem ersten Isolierwerkstoff (5a) hergestellt wird, in dem die Partikel (4) mit Abstand zueinander und zu den Kontaktstellen (3) angeordnet werden, wobei der erste Isolierwerkstoff (5a) in flüssiger Form auf die Kontaktstelle(n) (3) aufgebracht und danach verfestigt wird, wobei der Isolierwerkstoff (5a) nach dem Beschichten der Kontaktstelle(n) mit der Kontaktierungsschicht (6) durch eine Wärmebehandlung zumindest in einem zwischen den Kontaktstellen (3) befindlichen Bereich aufgeschmolzen wird, wobei in dem aufgeschmolzen Bereich die Lage wenigstens eines Partikels (4) mit Hilfe eines Magnetfelds derart verändert wird, dass die Kontaktstellen (3) über den wenigstens einen Partikel (4) elektrisch miteinander verbunden sind, und wobei der Isolierwerkstoff (5a) danach durch Abkühlen verfestigt wird, **dadurch gekennzeichnet, dass** die Partikel (4) mit einem zweiten, durch ein Polymer gebildeten Isolierwerk stoff (5b) ummantelt und danach auf die Kontaktstelle(n) (3) des mindestens einen Halbleiterchips (2) aufgebracht werden, und dass bei der Wärmebehandlung zusätzlich zu dem ersten Isolierwerkstoff (5a) auch der zweite Isolierwerkstoff (5b) aufgeschmolzen wird.

2. Verfahren nach Anspruch 1, **dadurch gekennzeichnet, dass** die Partikel (4) als längliche, vorzugsweise stabförmige Elemente ausgebildet sind.

3. Verfahren nach Anspruch 1 oder 2, **dadurch gekennzeichnet, dass** die Kontaktierungsschicht (6) derart auf die mindestens eine Kontaktstelle (3) aufgebracht wird, dass die Partikel (4) mit ihrer Längserstreckung etwa parallel zur Oberfläche der Kontaktstelle (3) ausgerichtet sind und dass nach dem Aufschmelzen der Isolierwerkstoffe (5a, 5b) mit Hilfe des Magnetfelds (8) mindestens ein Partikel (4) quer und insbesondere etwa rechtwinklig zur Oberfläche der Kontaktstelle (3) ausgerichtet wird.

4. Verfahren nach einem der Ansprüche 1 bis 3, **dadurch gekennzeichnet, dass** die Partikel (4) Spitzen oder Kanten aufweisen und vorzugsweise nadelförmig ausgebildet sind und dass die Partikel (4) mit Hilfe des Magnetfelds (8) derart in den Isolierwerkstoffen (5a, 5b) ausgerichtet und/oder positioniert werden, dass wenigstens ein Partikel (4) mit mindestens einer Spitze oder Kante eine Kontaktstelle (3) berührt und/oder in den Werkstoff der Kontaktstelle (3) eindringt.

5. Verfahren nach einem der Ansprüche 1 bis 4, **dadurch gekennzeichnet, dass** der Abstand (A) der einander zugewandten Kontaktstellen (3) der Halbleiterchips (2) größer gewählt wird als die Länge (L) der Partikel (4), und dass nach dem Aufschmelzen der Isolierwerkstoffe (5a, 5b) mindestens zwei Partikel (4) mit Hilfe des Magnetfelds (8) derart in Erstreckungsrichtung der Partikel (4) zueinander versetzt angeordnet werden, dass sie wenigstens eine sich durchgängig über mehrere Partikel (4) erstreckende Partikelreihe bilden, welche die Kontaktstellen (3) elektrisch miteinander verbindet.

6. Verfahren nach einem der Ansprüche 1 bis 5, **dadurch gekennzeichnet, dass** die Halbleiterchips (2) derart angeordnet werden, dass sie mit ihren Erstreckungsebenen parallel zueinander verlaufen und durch die Kontaktierungsschicht (6) voneinander beabstandet sind.

7. Verfahren nach einem der Ansprüche 1 bis 6, **dadurch gekennzeichnet, dass** die Wärmebehandlung durch Bestrahlung der Kontaktierungsschicht (6) mit elektromagnetischer Strahlung (7) erfolgt, insbesondere mit Infrarot strahlung und/oder Mikrowellen, und dass die Strahlung (7) vorzugsweise durch wenigstens einen der Halbleiterchips (2) hindurch in die Kontaktierungsschicht (6) eingekoppelt wird.

8. Verfahren nach einem der Ansprüche 1 bis 7, **dadurch gekennzeichnet, dass** die Strahlung (7) zu einem Energiestrahl gebündelt wird, und dass der Energiestrahl nacheinander aufwenigstens zwei voneinander beabstandete Bereiche der Kontaktierungsschicht (6) gerichtet wird.

9. Verfahren nach einem der Ansprüche 1 bis 8, **dadurch gekennzeichnet, dass** auf die wenigstens eine elektrische Kontaktstelle (3) mindestens eines Halbleiterchips (2) eine dünne Haftschicht und auf mindestens einen weiteren Halbleiterchip (2) die Kontaktierungsschicht (6) aufgebracht wird, dass nach dem Abkühlen der Isolierwerkstoffe (5a, 5b) der Kontaktierungsschicht (6) die Halbleiterchips (2) derart angeordnet werden, dass sie mit ihren Kontaktstellen (3) einander zugewandt sind und die Haftschicht an der Kontaktierungsschicht (6) anliegt, und dass die Halbleiterchips (2) danach derart aneinander angepresst werden, dass sich die Isolierwerkstoffe (5a, 5b) plastisch verformen und die Partikel (4) der Kontaktierungsschicht (6) die Haftschicht durchdringen.

10. Verfahren nach einem der Ansprüche 1 bis 9, **dadurch gekennzeichnet, dass** mindestens zwei quer zueinander verlaufende Energiestrahlen derart auf die Kontaktierungsschicht (6) ausgerichtet werden, dass sie sich zwischen zwei Kontaktstellen (3) durchdringen.

11. Verfahren nach einem der Ansprüche 1 bis 10, **dadurch gekennzeichnet, dass** die Mikrowellen- und/oder Infrarot-Strahlung (7) durch eine Maske hindurch auf die Kontaktierungsschicht (6) projiziert wird, und dass die Maske vorzugsweise an der der Kontaktierungsschicht (6) abgewandten Rückseite eines der Halbleiterchips (2) angeordnet ist.

12. Verfahren nach einem der Ansprüche 1 bis 11, **dadurch gekennzeichnet, dass** mindestens drei Halbleiterchips (2) mit ihren Erstreckungsebenen etwa parallel zueinander angeordnet und zu einem Schichtstapel miteinander verbunden werden, dass zwischen zwei zueinander benachbarten Halbleiterchips (2) jeweils eine Kontaktierungsschicht (6) angeordnet wird, und dass die Isolierwerkstoffe (5a, 5b) der Kontaktierungsschichten (6) derart gewählt werden, dass die Kontaktierungsschichten (6) für die elektromagnetische Strahlung unterschiedliche Absorptionselgenschaften aufweisen.

13. Verfahren nach einem der Ansprüche 1 bis 12, **dadurch gekennzeichnet, dass** die Kontaktierungsschicht (6) derart auf wenigstens einen der Halbleiterchips (2) aufgetragen wird, dass sie sich unterbrechungsfrei über mehrere voneinander beabstandete Kontaktstellen (3) des Halbleiterchips (2) erstreckt.

14. Chipanordnung (1), **dadurch gekennzeichnet, dass** sie nach dem Verfahren nach einem der Ansprüche 1 bis 13 hergestellt ist.

15. Lack, insbesondere zur Durchführung des Verfahrens nach einem der Ansprüche 1 bis 1 3, wobei der Lack ein Lösungsmittel und mindestens einen darin gelösten ersten elektrischen Isolierwerkstoff (5a) enthält, der durch Verdunsten des Lösungsmittels verfestigt werden kann, und wobei in dem ersten Isolierwerkstoff (5a) ferromagnetische Partikel (4) angeordnet sind, wobei die Partikel (4) mit einem zweiten, als Polymer ausgebildeten elektrischen Isolierwerkstoff (5b) beschichtet sind, und wobei der in verfestigtem Zustand befindliche erste Isolierwerkstoff (5a) und der zweite Isolierwerkstoff (5b) durch Wärmeeinwirkung schmelzbar sind.

16. Lack nach Anspruch 15, **dadurch gekennzeichnet, dass** die ferromagnetischen Partikel (4) Spitzen und/oder scharfe Kanten aufweisen.

17. Lack nach Anspruch 15 oder 16, **dadurch gekennzeichnet, dass** die Partikel (4) länglich, vorzugsweise stab- oder nadelförmig ausgebildet sind.

18. Lack nach einem der Ansprüche 15 bis 17, **dadurch gekennzeichnet, dass** die Länge oder die größte Abmessung der Partikel (4) kleiner als 10 µm, gegebenenfalls kleiner als 1 µm, insbesondere kleiner als 100 nm und bevorzugt kleiner als 10 nm ist.

19. Lack nach einem der Ansprüche 15 bis 18, **dadurch gekennzeichnet, dass** die gegebenenfalls mit dem zweiten Isolierwerkstoff (5b) beschichteten ferromagnetischen Partikel (4) in der aus dem Lösungsmittel und dem Isolierwerkstoff(5a) bestehenden Lösung suspendiert sind.

## Claims

1. Method for the production of a chip arrangement (1), at least two semiconductor chips (2), each having at least one electrical contact pad (3), being provided, the contact pad(s) (3) of at least one of the semiconductor chips (2) being coated with a contacting layer (6) having ferromagnetically electrically conductive particles (4), the semiconductor chips (2) being arranged in such a way that they are facing one another with their contact pads (3) and the contact pads (3) are connected to one another by the contacting layer (6) located between them, the contacting layer (6) being produced from these particles (4) and a first insulating material (5a), in which the particles (4) are arranged at a distance from one another and from the contact pads (3), the first insulating material (5a) being applied to the contact pad(s) (3) in liquid form and then solidified, the insulating material (5a) being melted by heat treatment, at least in a region located between the contact pads (3), after the coating of the contact pad(s) with the contacting layer (6), the position of at least one particle (4) in the melted region being changed with the aid of a magnetic field in such a way that the contact pads (3) are electrically connected to one another via the at least one particle (4), and the insulating material (5a) then being solidified by cooling, **characterized in that** the particles (4) are encapsulated with a second insulating material (5b), formed by a polymer, and then applied to the contact pad(s) (3) of the at least one semiconductor chip (2), and **in that** in the heat treatment the second insulating material (5b) is also melted in addition to the first insulating material (5a).

2. Method according to Claim 1, **characterized in that** the particles (4) are formed as elongated, preferably rod-shaped elements.

3. Method according to Claim 1 or 2, **characterized in that** the contacting layer (6) is applied to the at least one contact pad (3) in such a way that the particles (4) are aligned with their longitudinal extent approximately parallel to the surface of the contact pad (3) and **in that**, after the melting of the insulating materials (5a, 5b), at least one particle (4) is aligned transversely, and in particular approximately at right angles, to the surface of the contact pad (3) with the aid of the magnetic field (8).

4. Method according to one of Claims 1 to 3, **characterized in that** the particles (4) have points or edges and are preferably given the form of needles and **in that** the particles (4) are aligned and/or positioned in the insulating materials (5a, 5b) with the aid of the magnetic field (8) in such a way that at least one particle (4) touches a contact pad (3) and/or penetrates into the material of the contact pad (3) with at least one point or edge.

5. Method according to one of Claims 1 to 4, **characterized in that** the distance (A) between the mutually facing contact pads (3) of the semiconductor chips (2) is chosen to be greater than the length (L) of the particles (4), and **in that**, after the melting of the insulating materials (5a, 5b), at least two particles (4) are arranged offset in relation to one another in the direction of extent of the particles (4) with the aid of the magnetic field (8) in such a way that they form at least one series of particles extending continuously over a number of particles (4), which electrically connects the contact pads (3) to one another.

6. Method according to one of Claims 1 to 5, **characterized in that** the semiconductor chips (2) are arranged in such a way that they run parallel to one another with their planes of extent and are spaced apart from one another by the contacting layer (6).

7. Method according to one of Claims 1 to 6, **characterized in that** the heat treatment takes place by irradiating the contacting layer (6) with electromagnetic radiation (7), in particular with infrared radiation and/or microwaves, and **in that** the radiation (7) is preferably coupled into the contacting layer (6) through at least one of the semiconductor chips (2).

8. Method according to one of Claims 1 to 7, **characterized in that** the radiation (7) is concentrated into an energy beam, and **in that** the energy beam is directed at at least two spaced-apart regions of the contacting layer (6) one after the other.

9. Method according to one of Claims 1 to 8, **characterized in that** a thin adhesive layer is applied to the at least one electrical contact pad (3) of at least one semiconductor chip (2) and the contacting layer (6) is applied to at least one further semiconductor chip (2), **in that**, after the cooling of the insulating materials (5a, 5b) of the contacting layer (6), the semiconductor chips (2) are arranged in such a way that they are facing one another with their contact pads (3) and the adhesive layer lies against the contacting layer (6), and **in that** the semiconductor chips (2) are then pressed against one another in such a way that the insulating materials (5a, 5b) plastically deform and the particles (4) of the contacting layer (6) penetrate the adhesive layer.

10. Method according to one of Claims 1 to 9, **characterized in that** at least two energy beams running transversely to one another are aligned with the contacting layer (6) in such a way that they penetrate one another between two contact pads (3).

11. Method according to one of Claims 1 to 10, **characterized in that** the microwave and/or infrared radiation (7) is projected through a mask onto the contacting layer (6), and **in that** the mask is preferably arranged on the back side of one of the semiconductor chips (2), facing away from the contacting layer (6).

12. Method according to one of Claims 1 to 11, **characterized in that** at least three semiconductor chips (2) are arranged with their planes of extent approximately parallel to one another and are connected to one another to form a layer stack, **in that** a contacting layer (6) is respectively arranged between two mutually neighbouring semiconductor chips (2), and **in that** the insulating materials (5a, 5b) of the contacting layers (6) are chosen in such a way that the contacting layers (6) have different absorption properties for the electromagnetic radiation.

13. Method according to one of Claims 1 to 12, **characterized in that** the contacting layer (6) is applied to at least one of the semiconductor chips (2) in such a way that it extends uninterruptedly over a number of spaced-apart contact pads (3) of the semiconductor chip (2).

14. Chip arrangement (1), **characterized in that** it is produced by the method according to one of Claims 1 to 13.

15. Varnish, in particular for carrying out the method according to one of Claims 1 to 13, the varnish containing a solvent and at least a first electrical insulating material (5a) dissolved in it, which can be solidified by evaporation of the solvent, and ferromagnetic particles (4) being arranged in the first insulating material (5a), the particles (4) being coated with a second electrical insulating material (5b), formed as a polymer, and the first insulating material (5a), in the solidified state, and the second insulating material (5b) being meltable by exposure to heat.

16. Varnish according to Claim 15, **characterized in that** the ferromagnetic particles (4) have points and/or sharp edges.

17. Varnish according to Claim 15 or 16, **characterized in that** the particles (4) are formed in an elongated manner, preferably given the form of rods or needles.

18. Varnish according to one of Claims 15 to 17, **characterized in that** the length or the greatest dimension of the particles (4) is less than 10 µm, optionally less than 1 µm, in particular less than 100 nm and preferably less than 10 nm.

19. Varnish according to one of Claims 15 to 18, **characterized in that** the ferromagnetic particles (4), optionally coated with the second insulating material (5b), are suspended in the solution comprising the solvent and the insulating material (5a).

## Revendications

1. Procédé pour fabriquer un agencement de puce (1), dans lequel au moins deux puces à semi-conducteurs (2) présentant chacune au moins un point de contact (3) électrique sont mises à disposition, dans lequel le(les) point(s) de contact (3) d'au moins l'une des puces à semi-conducteurs (2) est/sont revêtu(s) d'une couche d'établissement de contact (6) présentant des particules (4) conductibles au plan ferromagnétique et électrique, dans lequel les puces à semi-conducteurs (2) sont disposées de telle sorte qu'elles sont tournées avec leurs points de contact (3) les unes vers les autres et les points de contact (3) sont reliés entre eux par la couche d'établissement de contact (6) se trouvant entre elles, dans lequel la couche d'établissement de contact (6) est fabriquée à partir de ces particules (4) et d'un premier matériau isolant (5a), dans lequel les particules (4) sont disposées à distance les unes des autres et à distance des points de contact (3), dans lequel le premier matériau isolant (5a) est appliqué sous forme liquide sur le(les) point(s) de contact (3) et durci ensuite, le matériau isolant (5a) étant fondu par un traitement thermique au moins dans une zone se trouvant entre les points de contact (3) après le revêtement du(des) point(s) de contact avec la couche d'établissement de contact (6), dans lequel la position d'au moins une particule (4) est modifiée dans la zone fondue à l'aide d'un champ magnétique de telle sorte que les points de contact (3) sont reliés électriquement entre eux au moyen de l'au moins une particule (4) et dans lequel le matériau isolant (5a) est durci ensuite par refroidissement, **caractérisé en ce que** les particules (4) sont enveloppées avec un second matériau isolant (5b) formé par un polymère et sont appliquées ensuite sur le(les) point(s) de contact (3) de l'au moins une puce à semi-conducteurs (2) et **en ce que**, lors du traitement thermique, également le second matériau isolant (5b) est fondu en supplément du premier matériau isolant (5a).

2. Procédé selon la revendication 1, **caractérisé en ce que** les particules (4) sont conçues comme des éléments allongés, de préférence en forme de barre.

3. Procédé selon la revendication 1 ou 2, **caractérisé en ce que** la couche d'établissement de contact (6) est appliquée sur l'au moins un point de contact (3) de telle sorte que les particules (4) sont orientées avec leur étirement longitudinal à peu près parallèlement à la surface du point de contact (3) et **en ce que**, après la fusion des matériaux isolants (5a, 5b), au moins une particule (4) est orientée à l'aide du champ magnétique (8) transversalement et en particulier à peu près perpendiculairement à la surface du point de contact (3).

4. Procédé selon l'une quelconque des revendications 1 à 3, **caractérisé en ce que** les particules (4) présentent des pointes ou des arêtes et sont formées de préférence en forme d'aiguille et **en ce que** les particules (4) sont orientées et/ou positionnées à l'aide du champ magnétique (8) dans les matériaux isolants (5a, 5b) de telle sorte qu'au moins une particule (4) touche avec au moins une pointe ou une arête un point de contact (3) et/ou pénètre dans le matériau du point de contact (3).

5. Procédé selon l'une quelconque des revendications 1 à 4, **caractérisé en ce que** l'espacement (A) des points de contact (3) tournés les uns vers les autres des puces à semi-conducteurs (2) est choisi plus grand que la longueur (L) des particules (4) et **en ce que**, après la fusion des matériaux isolants (5a, 5b), au moins deux particules (4) sont disposées décalées l'une par rapport à l'autre à l'aide du champ magnétique (8) dans le sens d'étirement des particules (4) de telle sorte qu'elles forment au moins une rangée de particules s'étendant de façon continue sur plusieurs particules (4), laquelle série relie les points de contact (3) électriquement entre eux.

6. Procédé selon l'une quelconque des revendications 1 à 5, **caractérisé en ce que** les puces à semi-conducteurs (2) sont disposées de telle sorte qu'elles sont agencées parallèlement entre elles avec leurs plans d'étirement et sont espacées les unes des autres par la couche d'établissement de contact (6).

7. Procédé selon l'une quelconque des revendications 1 à 6, **caractérisé en ce que** le traitement thermique s'effectue par irradiation de la couche d'établissement de contact (6) avec un rayonnement (7) électromagnétique, en particulier par du rayonnement infrarouge et/ou des micro-ondes, et **en ce que** le rayonnement (7) est injecté de préférence à travers au moins l'une des puces à semi-conducteurs (2) dans la couche d'établissement de contact (6).

8. Procédé selon l'une quelconque des revendications 1 à 7, **caractérisé en ce que** le rayonnement (7) est focalisé en un faisceau d'énergie, et **en ce que** le faisceau d'énergie est orienté successivement sur au moins deux zones espacées l'une de l'autre de la couche d'établissement de contact (6).

9. Procédé selon l'une quelconque des revendications 1 à 8, **caractérisé en ce qu'**une couche d'adhérence mince est appliquée sur l'au moins un point de contact (3) électrique d'au moins une puce à semi-conducteurs (2) et la couche d'établissement de contact (6) est appliquée sur au moins une autre puce à semi-conducteurs (2), **caractérisé en ce que**, après le refroidissement des matériaux isolants (5a, 5b) de la couche d'établissement de contact (6), les puces à semi-conducteurs (2) sont disposées de telle sorte qu'elles sont tournées avec leurs points de contact (3) les unes vers les autres et **en ce que** la couche d'adhérence s'appuie sur la couche d'établissement de contact (6) et **en ce que** les puces à semi-conducteurs (2) sont pressées ensuite les unes sur les autres de telle sorte que les matériaux isolants (5a, 5b) se déforment plastiquement et les particules (4) de la couche d'établissement de contact (6) pénètrent la couche d'adhérence.

10. Procédé selon l'une quelconque des revendications 1 à 9, **caractérisé en ce qu'**au moins deux faisceaux d'énergie s'étendant transversalement l'un par rapport à l'autre sont orientés sur la couche d'établissement de contact (6) de telle sorte qu'ils s'interpénètrent entre deux points de contact (3).

11. Procédé selon l'une quelconque des revendications 1 à 10, **caractérisé en ce que** le rayonnement à micro-ondes et/ou le rayonnement infrarouge (7) est projeté à travers un masque sur la couche d'établissement de contact (6) et **en ce que** le masque est disposé de préférence sur le côté arrière, opposé à la couche d'établissement de contact (6), de l'une des puces à semi-conducteurs (2).

12. Procédé selon l'une quelconque des revendications 1 à 11, **caractérisé en ce qu'**au moins trois puces à semi-conducteurs (2) sont disposées à peu près parallèlement entre elles avec leurs plans d'étirement et sont reliées entre elles pour former une pile de couche, **en ce que** à chaque fois une couche d'établissement de contact (6) est disposée entre deux puces à semi-conducteurs (2) voisines l'une de l'autre et **en ce que** les matériaux isolants (5a, 5b) des couches d'établissement de contact (6) sont choisis de telle sorte que les couches d'établissement de contact (6) présentent des propriétés d'absorption différentes pour le rayonnement électromagnétique.

13. Procédé selon l'une quelconque des revendications 1 à 12, **caractérisé en ce que** la couche d'établissement de contact (6) est appliquée sur au moins l'une des puces à semi-conducteurs (2) de telle sorte qu'elle s'étend sans interruption sur plusieurs points de contact (3), espacés les uns des autres, de la puce à semi-conducteurs (2).

14. Agencement (1) de puce, **caractérisé en ce qu'**il est fabriqué selon le procédé selon l'une quelconque des revendications 1 à 13.

15. Laque, en particulier pour la mise en oeuvre du procédé selon l'une quelconque des revendications 1 à 13, la laque contenant un solvant et au moins un premier matériau isolant (5a) électrique dissout dans celui-ci, lequel peut être durci par l'évaporation du solvant, et des particules (4) ferromagnétiques étant disposées dans le premier matériau isolant (5a), les particules (4) étant revêtues avec un second matériau isolant (5b) électrique et conçu comme polymère, et le premier matériau isolant (5a) se trouvant dans l'état durci et le second matériau isolant (5b) pouvant être fondus par effet de chaleur.

16. Laque selon la revendication 15, **caractérisée en ce que** les particules (4) ferromagnétiques présentent des pointes et/ou des arêtes aiguisées.

17. Laque selon la revendication 15 ou 16, **caractérisée en ce que** les particules (4) sont conçues allongées, de préférence en forme de barre ou d'aiguille.

18. Laque selon l'une quelconque des revendications 15 à 17, **caractérisée en ce que** la longueur ou la plus grande dimension des particules (4) est inférieure à 10 *µ*m, éventuellement inférieure à 1 *µ*m, en particulier inférieure à 100 nm et de préférence inférieure à 10 nm.

19. Laque selon l'une quelconque des revendications 15 à 18, **caractérisée en ce que** les particules (4) ferromagnétiques revêtues éventuellement avec le second matériau isolant (5b) sont suspendues dans la solution constituée du solvant et du matériau isolant (5a).
